# EUROPEAN PATENT APPLICATION

(11) **EP 1 930 942 A1**
(43) Date of publication of application: **11.06.2008**
(21) Application number: 05784063.9
(22) Date of filing: 08.09.2005
(51) Int. Cl.: H01L 23/34

(54) **A HEAT SINKING MODULE CONSTRUCTION FOR HEATING COMPONENT**

(71) Applicant: NeoBulb Technologies, Inc., Bandar Seri Begawan (BN)
(72) Inventor: CHEN, Jen-Shyan, Taiwan 30046 (CN)
(74) Representative: Becker, Bernd
(86) International application number: PCT/CN2005/001430
(87) International publication number: WO 2007/028277

(57) **Abstract**

The invention is to provide a heat dissipating module structure for a heat generating device. The heat dissipating module structure according to a preferred embodiment of the invention includes a heat-conducting device, a carrier, and a heat-conducting material. The first end of the heat-conducting device is inserted into the bore such that the top of the first end of the heating-conducting device is aligned with or close to the upper surface of the carrier. The heat-conducting material surrounds the upper surface of the carrier such that the heat-conducting material together with the upper surface provides a supporting plane. The heat generating device is to be mounted on the supporting plane. Moreover, the heat generated from the heat generating device is conducted from the first end of the heat-conducting device to the second end of the heat-conducting device.

## Description

### BACKGROUND OF THE INVENTION

### 1. Field of the invention

The invention relates to a heat dissipating module structure, and more particularly, to a heat dissipating module structure for a heat generating device.

### 2. Description of the prior art

With the development of technology, there has not been any breakthrough for the techniques of many electronic products due to the problem of heat-dissipation. For example, a large amount of heat is generated during the operation of the central micro-processor in a computer. If the heat can not be dissipated, it will lead to negative effect on the operation of the whole system. Another example is the high power light-emitting diode illuminating equipment that has been extensively applied and is being continually investigated and developed. Although having the advantages of electricity-saving and vibration-resisting, current high power light-emitting diode illuminating equipment has the problem of overheating after being used for a long span of time, contributing to the reduction of lighting efficiency of the light-emitting diode and limiting the brightness. Therefore, a heat dissipating module structure is essential to the enhancement of the efficiency of the electronic products.

### SUMMARY OF THE INVENTION

Accordingly, a scope of the invention is to provide a heat dissipating module structure for a heat generating device.

The first preferred embodiment of the invention provides a heat dissipating module structure for a heat generating device. The heat dissipating module structure includes a heat-conducting device, a carrier, and a heat-conducting material. The heat-conducting device has a first end and a second end. The carrier has an upper surface, a bottom surface, and a hollow bore adapted to receive the first end of the heat-conducting device. The heat-conducting device is inserted via the first end thereof into the bore, such that the top of the first end of the heat-conducting device is disposed near or aligned with the upper surface of the carrier. The heat-conducting material surrounds the upper surface of the carrier, such that the heat-conducting material together with the upper surface of the carrier provides a supporting plane. The heat generating device is to be mounted on the supporting plane. Moreover, the heat generated by the heat generating device is conducted from the first end of the heat-conducting device to the second end of the heating-conducting device.

A heat dissipating module structure for a heat generating device, according to the second preferred embodiment of the invention, includes a heat-conducting device, a carrier, and a heat-conducting material. The heat-conducting device has a first end and a second end. The carrier has an upper surface, a bottom surface, and a groove formed on the bottom surface. The first end of the heat-conducting device is disposed into the groove. The heat-conducting material fills up a residual space between the first end of the heat-conducting device and the groove. The heat generating device is mounted on the upper surface of the carrier. Moreover, the heat generated from the heat generating device is conducted from the carrier through the heat-conducting material and the first end of the heat-conducting device to the second end of the heating-conducting device.

The advantage and spirit of the invention may be understood by the following recitations together with the appended drawings.

### BRIEF DESCRIPTION OF THE APPENDED DRAWINGS

FIG. 1A is an outside perspective view of the heat dissipating module structure 1 according to the first preferred embodiment of the invention.
FIG. 1B is an outside perspective view of the carrier 12 in FIG. 1A.
FIG. 1C is a cross section view of the carrier 12 of the heat dissipating module structure 1 in FIG. 1A.
FIG. 1D is another cross section view of the carrier 12 of the heat dissipating module structure 1 in FIG. 1A.
FIG. 1E is the perspective view relating the two cross section views of the carrier 12 of the heat dissipating module structure 1 in FIG. 1A, describing the manufacturing process of the heat dissipating module structure 1.
FIG. 2 is a cross section view of a heat pipe of the heat-conducting device 10 in FIG. 1A.
FIG. 3 is another outside perspective view of the heat dissipating module structure 1 according to the first preferred embodiment of the invention.
FIG. 4A is an outside perspective view of the heat dissipating module structure 2 according to the second preferred embodiment of the invention.
FIG. 4B is an outside perspective view of the carrier 22 in FIG. 4A.

### DETAILED DESCRIPTION OF THE INVENTION

The invention provides a heat dissipating module structure for a heat generating device.

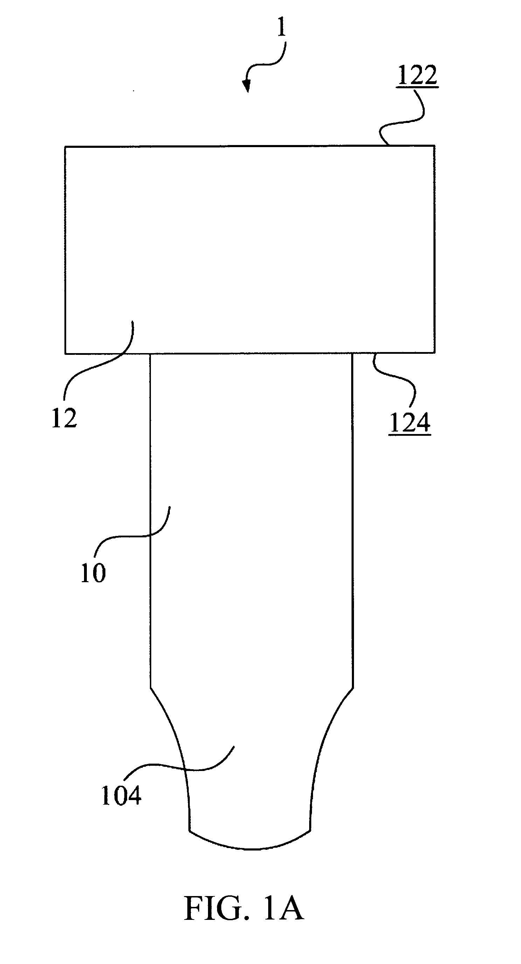

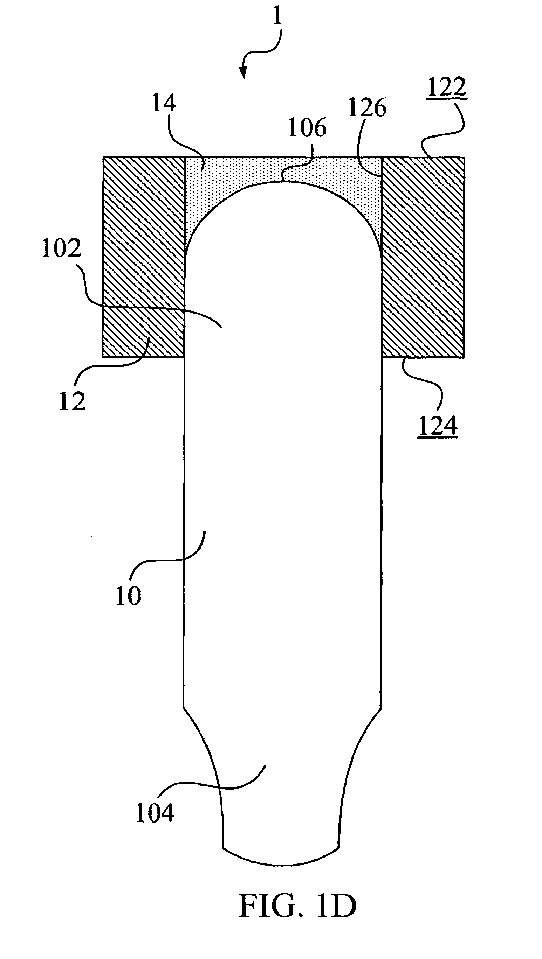

Referring to FIG. 1A through FIG. IE, the heat dissipating module structure 1 according to the first preferred embodiment of the invention is revealed in the figures.

FIG. 1A is an outside perspective view of the heat dissipating module structure 1. As shown in FIG. 1A, the heat dissipating module structure 1 includes a heat-conducting device 10, a carrier 12, and a heat-conducting material 14. The heat-conducting device 10 has a first end 102 and a second end 104.

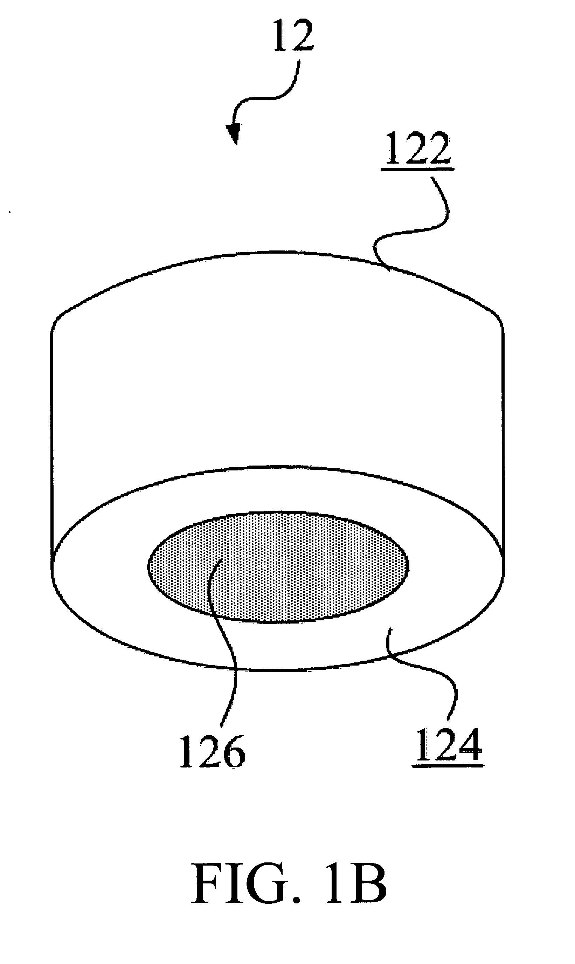

FIG. 1B is an outside perspective view of the carrier 12 in FIG. 1A. As shown in FIG. 1B, the carrier 12 has an upper surface 122, a bottom surface 124, and a hollow bore 126.

In one embodiment, the carrier 12 is formed of a metal material, a ceramic material, or a polymer material.

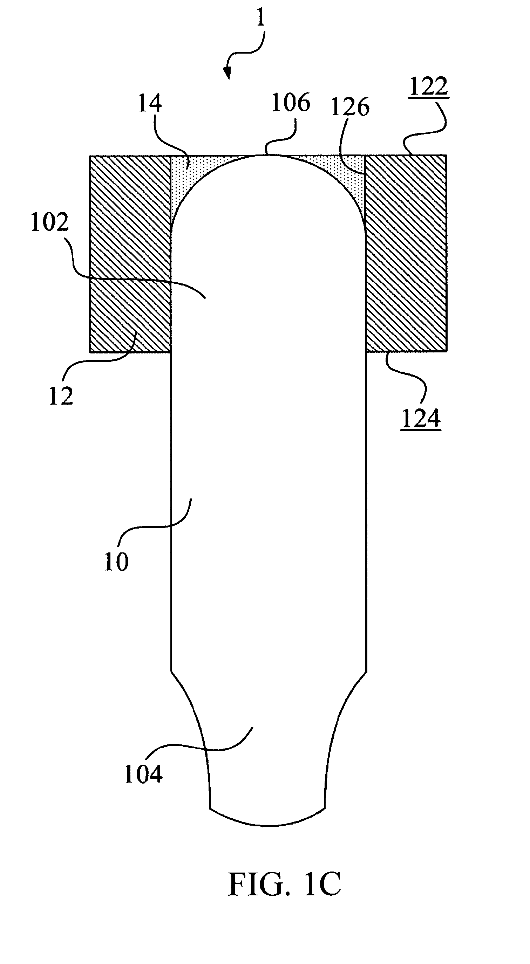

FIG. 1C is a cross section view of the carrier 12 of the heat dissipating module structure 1. As shown in FIG. 1C, the hollow bore 126 of the carrier 12 is adapted to receive the first end 102 of the heat-conducting device 10. The heat-conducting device 10 is inserted via the first end 102 thereof into the bore 126 such that the top 106 of the first end 102 of the heat-conducting device 10 is disposed near or aligned with the upper surface 122 of the carrier 12.

The heat-conducting material 14 surrounds the upper surface 122 of the carrier 12 such that the heat-conducting material 14 together with the upper surface 122 of the carrier 12 provide a supporting plane.

In one embodiment, the top 106 of the first end 102 of the heat-conducting device 10 is aligned with the upper surface 122 of the carrier 12 as shown in FIG. C. The heat-conducting material 14 fills up a residual space formed by the gap between the bore 126 and the first end 102 of the heat-conducting device 10. Practically, the carrier 12 and the heat-conducting material 14 need to be smoothed further, such that the heat-conducting material 14 together with the upper surface 122 of the carrier 12 provides a supporting plane.

In another embodiment, a distance exists between the upper surface 122 of the carrier 12 and the top 106 of the first end 102 of the heat-conducting device 10 as shown in FIG. D. The heat-conducting material 14 fills up a residual space, formed due to the distance, in the bore 126 near the upper surface 122 of the carrier 12. In practice, the carrier 12 and the heat-conducting material 14 need to be smoothed further, such that the heat-conducting material 14 together with the upper surface 122 of the carrier 12 provides a supporting plane.

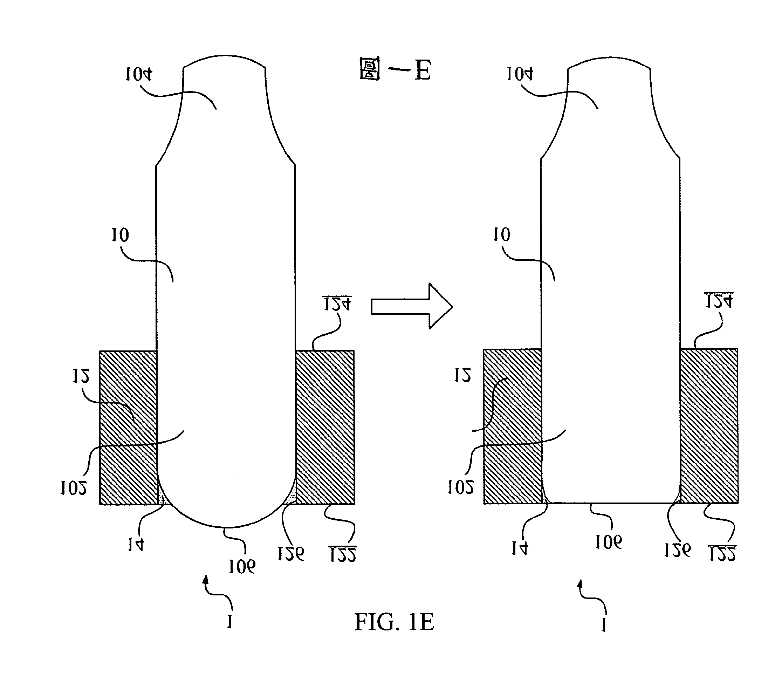

In another embodiment, referring to FIG. 1E, the top 106 of the first end 102 of the heat-conducting device 10 is disposed outside the bore 126 (as shown in the partial cross section view of the heat dissipating module structure 1 on the left side of FIG. 1E), and then it is grinded, so that the top 106 of the first end 102 of the heat-conducting device 10 is aligned with the upper surface 122 of the carrier 12 (as shown in the partial cross section view of the heat dissipating module structure 1 on the right side of FIG. 1E). The heat-conducting material 14 fills up a residual space formed by the gap between the bore 126 and the first end 102 of the heat-conducting device 10. In practice, the carrier 12 and the heat-conducting material 14 need to be smoothed further, such that the heat-conducting material 14 together with the upper surface 122 of the carrier 12 provide a supporting plane.

It should be noted that the corresponding heat generating device (not shown in the figure) is to be mounted on the plane. Moreover, the heat generated by the heat generating device during operation thereof is conducted from the first end 102 of the heat-conducting device 10 to the second end 104 of the heating-conducting device 10.

In one embodiment, the heat-conducting material 14 is a heat-conducting paste such as a solder paste, a silver paste, a copper paste, or a paste material containing metal particles or ceramic particles. Practically, the heat-conducting paste fills up the residual space in the bore and then is cured.

In one embodiment, the heat-conducting device 10 is a heat pipe or a cylinder device formed of a material with high heat conductivity.

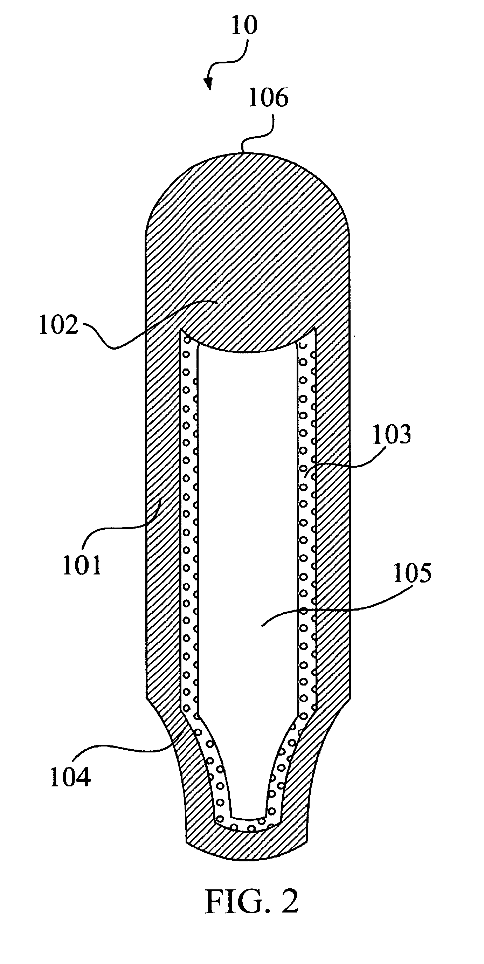

Referring to FIG. 2, a cross section view of the heat pipe is revealed and illustrated as the heat-conducting device 10. The heat-conducting pipe 10 includes a sealed metal pipe 101 and a porous capillary diversion layer 103. The metal pipe 101 has a vacuumed capacity 105 where there is a working fluid (not shown in the figure). The porous capillary diversion layer 103 is formed inside the capacity 105 and covers the inner wall of the metal pipe 101. What needs to be explained is that one end of the sealed metal pipe 101, which is originally unsealed, is sealed by heli-arc welding. Therefore, as shown in the cross section view of the heat pipe 10 in FIG. 2, the top 106 of the first end 102 of the heat pipe 10 is cohered to form a sphere after being heated.

In one embodiment, the heat dissipating module structure 1 further includes at least one heat-dissipating fin. The at least one heat-dissipating fin is mounted on a periphery of the heat-conducting device 10. In another embodiment, the heat dissipating module structure 1 further includes a heat sink. The heat sink is mounted on the second end 104 of the heat-conducting device 10.

The heat dissipating module structure, according to the second preferred embodiment of the invention, includes a heat-conducting device, a carrier formed of a material with high heat conductivity, and a heat-conducting paste.

The heat-conducting device, having a first end and a second end, is a heat pipe or a cylinder device formed of a material with high heat conductivity. The first end 11 forms a spherical surface inside and outside by sintering. Moreover, the heat-conducting device includes a sealed metal pipe and a porous capillary diversion layer.

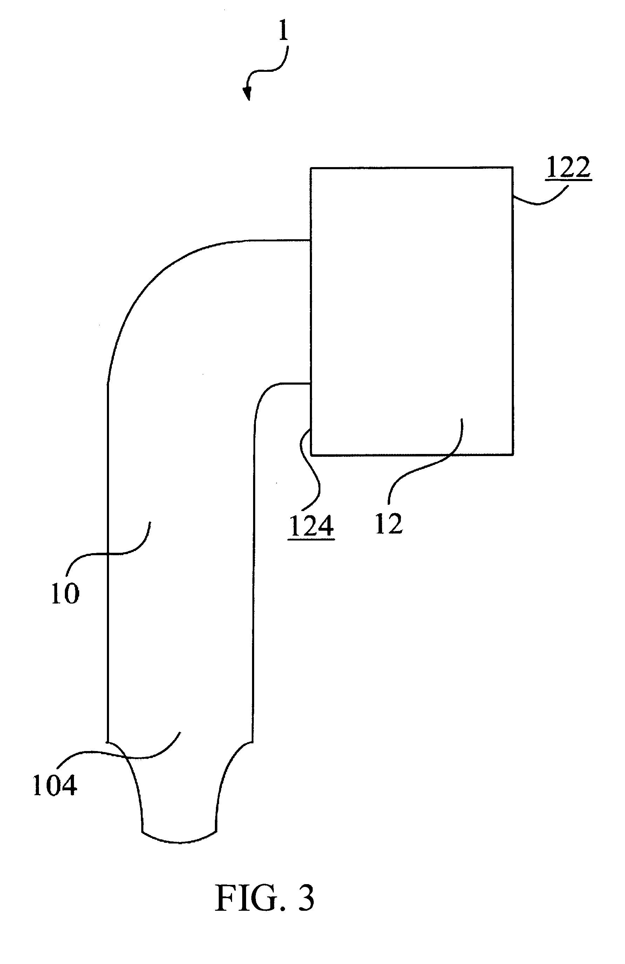

Referring to FIG. 1A, the shape of the heat-conducting device 10 of the heat dissipating module structure 1 according to the invention could be a straighten pipe for practical application. Referring to FIG. 3, for particular application, the shape of the heat-conducting device 10 of the heat dissipating module structure 1 according to the invention could be bended appropriately upon practical demand.

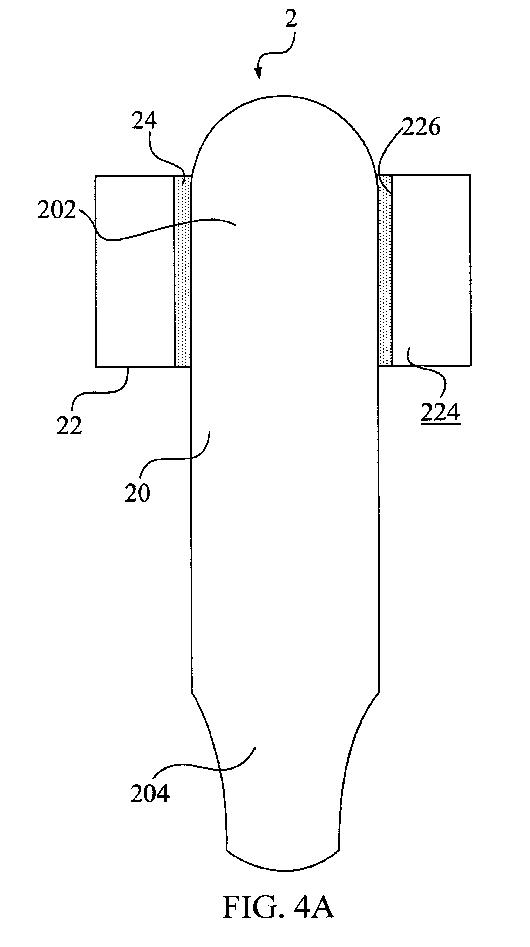

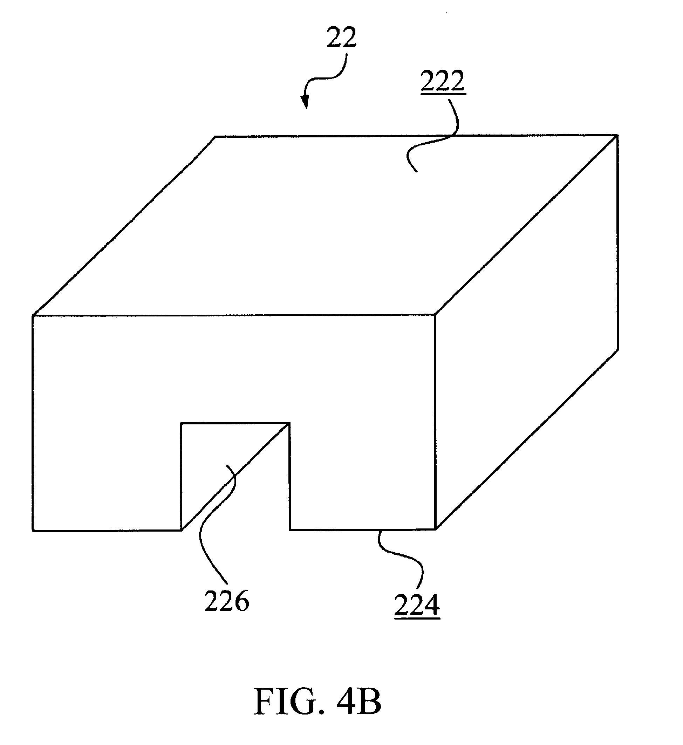

Referring to FIG. 4A and FIG. 4B, the heat dissipating module structure 2 according to the second preferred embodiment of the invention is revealed in the figure.

FIG. 4A is an outside perspective view of the heat dissipating module structure 2. Referring to FIG. 4A, the heat dissipating module structure 2 includes a heat-conducting device 20, a carrier 22, and a heat-conducting material 24. The heat-conducting device 20 has a first end 202 and a second end 204.

FIG. 4B is an outside perspective view of the carrier 22. Referring to FIG. 4B, the carrier 22 has an upper surface 222, a bottom surface 224, and a groove 226. The groove 226 of the carrier 22 is formed on the bottom surface 224 and adapted to receive the first end 202 of the heat-conducting device 20.

Referring to FIG. 4A, the first end 202 of the heat-conducting device 20 is disposed into the groove 226. The heat-conducting material 24 fills up a residual space between the first end 202 of the heat-conducting device 20 and the groove 226.

It should be noted that the corresponding heat generating device (not shown in the figure) is to be mounted on the upper surface 222 of the carrier 22. Moreover, the heat generated by the heat generating device during operation thereof is conducted from the carrier 22 through the heat-conducting material 24 and the first end 202 of the heat-conducting device 20 to the second end 204 of the heating-conducting device 20. Practically, the outer diameter of the first end 202 of the heat-conducting device 20 is substantially equal to the depth of the groove 226 and is also allowed to be less or larger than the depth of the groove 226.

The material, manufacturing process, and the shape of each device in the heat dissipating module 2 according to the second preferred embodiment of the invention are the same with those of each device in the heat dissipating 1 according to the first preferred embodiment of the invention. Hence, descriptions will not be repeated here.

In one embodiment, the heat dissipating module structure 2 further includes at least one heat-dissipating fin. The at least one heat-dissipating fin is mounted on a periphery of the heat-conducting device 20. In another embodiment, the heat dissipating module structure 1 further includes a heat sink. The heat sink is mounted on the second end 204 of the heat-conducting device 20.

With the example and explanations above, the features and spirits of the invention will be hopefully well described. Those skilled in the art will readily observe that numerous modifications and alterations of the device may be made while retaining the teaching of the invention. Accordingly, the above disclosure should be construed as limited only by the metes and bounds of the appended claims.

## Claims

1. A heat dissipating module structure for a heat generating device, the heat dissipating module structure comprising:
a heat-conducting device having a first end and a second end;
a carrier having an upper surface, a bottom surface and a hollow bore, the first end of the heat-conducting device being inserted into the hollow bore and the top of the first end of the heat-conducting device is disposed near or aligned with the upper surface of the carrier; and
a heat-conducting material surrounding the upper surface of the carrier such that the heat-conducting material together with the upper surface of the carrier provides a supporting plane;
whereby when the heat generating device is mounted on the supporting plane, the heat generated from the heat generating device is conducted from the first end of the heat-conducting device to the second end of the heating-conducting device.

2. The heat dissipating module structure of claim 1, wherein the top of the first end of the heat-conducting device is aligned with the upper surface of the carrier.

3. The heat dissipating module structure of claim 2, wherein the top of the first end of the heat-conducting device is disposed outside the bore, and then grinded so that the first end of the heat-conducting device is aligned with the upper surface of the carrier.

4. The heat dissipating module structure of claim 1, wherein a distance exists between the upper surface of the carrier and the top of the first end of the heat-conducting device.

5. The heat dissipating module structure of claim 1, wherein the carrier is formed of a metal material, a ceramic material or a polymer material.

6. The heat dissipating module structure of claim 1, wherein the heat conducting material is a heat-conducting paste, the heat-conducting paste fills up the residual space in the bore, and then it is cured.

7. The heat dissipating module structure of claim 1, wherein the heat-conducting paste is one selected from the group consisting of a solder paste, a silver paste, copper paste, a paste material containing metal particles and a paste material containing ceramic particles.

8. The heat dissipating module structure of claim 1, wherein the heat-conducting device is a heat pipe or a cylinder device formed of a material with high heat conductivity.

9. The heat dissipating module structure of claim 1, further comprising at least one heat-dissipating fin mounted on a periphery of the heat-conducting device.

10. The heat dissipating module structure of claim 1, further comprising a heat sink mounted on the second end of the heat-conducting device.

11. A heat dissipating module structure for a heat generating device, the heat dissipating module structure comprising:
a heat-conducting device having a first end and a second end;
a carrier having an upper surface, a bottom surface and a groove, the groove formed on the bottom surface and the first end of the heat-conducting device being disposed into the groove; and
a heat-conducting material, filling up a residual space between the first end of the heat-conducting device and the groove;
whereby when the heat generating device is mounted on the upper surface of the carrier, the heat generated from the heat generating device is conducted from the carrier through the heat-conducting material and the first end of the heat-conducting device to the second end of the heating-conducting device.

12. The heat dissipating module structure of claim 11, wherein the outer diameter of the first end of the heat-conducting device is substantially equal to the depth of the groove.

13. The heat dissipating module structure of claim 11, wherein the outer diameter of the first end of the heat-conducting device is less than the depth of the groove.

14. The heat dissipating module structure of claim 11, wherein the outer diameter of the first end of the heat-conducting device is larger than the depth of the groove.

15. The heat dissipating module structure of claim 11, wherein the carrier is formed of a metal material or a ceramic material.

16. The heat dissipating module structure of claim 11, wherein the heat-conducting material is a heat-conducting paste, the heat-conducting paste fills up the residual space in the groove and then is cured.

17. The heat dissipating module structure of claim 16, wherein the heat-conducting paste is one selected from the group consisting of a solder paste, a silver paste, copper paste, a paste material containing metal particles and a paste material containing ceramic particles.

18. The heat dissipating module structure of claim 11, wherein the heat-conducting device is a heat pipe or a cylinder device formed of a material with high heat conductivity.

19. The heat dissipating module structure of claim 11, further comprising at least one heat-dissipating fin mounted on a periphery of the heat-conducting device.

20. The heat dissipating module structure of claim 11, further comprising a heat sink mounted on the second end of the heat-conducting device.
